**Europäisches Patentamt**

**European Patent Office**

**Office européen des brevets**

(11) Veröffentlichungsnummer: **0 021 149**
**B1**

(19)

# (12) EUROPÄISCHE PATENTSCHRIFT

(45) Veröffentlichungstag der Patentschrift:
02.03.83

(51) Int. Cl.³: **C 09 D 9/00, C 11 D 7/32,**
**H 01 L 21/306**

(21) Anmeldenummer: 80103088.3

(22) Anmeldetag: 03.06.80

(54) Reinigungszusammensetzung, Verfahren zu ihrer Herstellung und Verwendung derselben.

(30) Priorität: 26.06.79 US 52160

(43) Veröffentlichungstag der Anmeldung:
07.01.81 Patentblatt 81/1

(45) Bekanntmachung des Hinweises auf die Patenterteilung:
02.03.83 Patentblatt 83/9

(84) Benannte Vertragsstaaten:
**DE FR GB**

(56) Entgegenhaltungen:
**DE-A-2 400 976**
**DE-A-2 513 236**
**DE-A-2 532 024**
**US-A-3 551 204**
**US-A-3 576 751**
**US-A-3 673 099**
**US-A-3 876 461**

(73) Patentinhaber: **International Business Machines Corporation, Armonk, N.Y. 10504 (US)**

(72) Erfinder: **Bakos, Peter, 530A Reuben Drive, Endicott New York 13760 (US)**
Erfinder: **Bendz, Gerald Andrei, R.D. 2 Mason Road, Vestal New York 13850 (US)**
Erfinder: **Darrow, Russell Elwood, R.D. 1 Stratton Road, Newark Valley New York 13811 (US)**
Erfinder: **Rivenburgh, Dennis Louis, 804 Buffalo Road, Endicott New York 13760 (US)**

(74) Vertreter. **Kreidler, Eva-Maria, Dr. rer. nat., Schönaicher Strasse 220, D-7030 Böblingen (DE)**

Reinigungszusammensetzung, Verfahren zu ihrer Herstellung und Verwendung derselben

Die Erfindung betrifft eine Reinigungszusammensetzung, ein Verfahren zu ihrer Herstellung und die Verwendung derselben. Sie ist besonders geeignet zur Entfernung von Lötflußmittelresten und Rückständen von Unterlagen, insbesondere bei der Herstellung integrierter Schaltkreismoduln. Außerdem ist die Reinigungszusammensetzung geeignet zur Entfernung verschiedener gehärteter synthetischer organischer Polymerüberzüge, insbesondere abdichtender Überzüge, beispielsweise gehärteter Polyimidüberzüge, die auf einem integrierten Schaltkreischip-Modul angeordnet sind.

Während der Herstellung integrierter Schaltkreismoduln werden Eingangs- und Ausgangs(I/O)stifte in die Unterlage eingeführt. Die Eingangs/Ausgangsstifte stellen die notwendigen elektrischen Verbindungen zu dem integrierten Schaltkreischip oder den Chips her, die nachfolgend auf die Unterlage oder den Träger aufgebracht werden. Wenn das Modul in einem Lötprozeß auf einer gedruckten Schaltkarte befestigt werden soll, müssen Lötflußmittelzusammensetzungen auf die Stifte aufgetragen werden. Flußmittelzusammensetzungen werden zur Entfernung von Oxiden von den Stiften angewendet und zur Verhinderung einer Oxidation der Stifte, wenn diese während des Lötens erhöhten Temperaturen ausgesetzt werden, wodurch die elektrische Leitfähigkeit der Stifte erhalten bleibt. Wenn das Lot einmal aufgetragen ist, müssen Flußmittelreste oder Rückstände derselben, d. h. Polymerprodukte, welche auf den Stiften und der Unterlage zurückbleiben, entfernt werden, damit die Unterlage so rein wie möglich ist. Das Auffinden einer geeigneten Zusammensetzung für die Entfernung von Flußmitteln oder Rückständen ist sehr schwierig. Im einzelnen muß die Zusammensetzung als selektives Lösungsmittel oder Dispersionsmittel für das Flußmittel und/oder die Flußmittelrückstände wirken, darf aber andererseits die Unterlage, die Stifte und andere Materialien, die auf den Unterlagen vorhanden sind, nicht nachteilig beeinflussen, beispielsweise durch Ätzen und dergleichen. Die Unterlagen können beispielsweise in festgelegten Bereichen bestimmte Metalle wie Kupfer und/oder Chrom enthalten, und wenn diese während des Reinigungsverfahrens weggelöst würden, würde das notwendige Metallisierungsmuster auf der Unterlage unterbrochen, wodurch das integrierte Schaltkreismodul für den beabsichtigten Zweck unbrauchbar würde. Die integrierten Halbleiterchips werden auf der Unterlage oder dem Träger befestigt durch Auftragen eines Lots in bestimmten Bereichen, die, wie allgemein üblich, als Chipanschlußstellenbereiche bezeichnet werden. Diese Bereiche können festgelegt werden, indem beispielsweise bestimmte Bereiche eines Metalls freigelegt werden, das sich mit dem Lot verbindet. Als solches ist beispielsweise Kupfer geeignet. Zusätzlich wird eine Flußmittelzusammensetzung auf die Unterlage aufgetragen, um die Anwendung des Lots im Chipanschlußstellenbereich zu erleichtern. Nachdem das Lot im Chipanschlußstellenbereich aufgetragen ist, müssen jegliche Flußmittelreste und/oder Flußmittelrückstände noch vor der Befestigung der integrierten Halbleiterchips entfernt werden, so daß das Modul so rein wie möglich ist.

Aus der deutschen Offenlegungsschrift 2 513 236 ist ein Schaum zur Entfernung von Farbe und Lack bekannt mit einem ausreichenden Gehalt an N-Methyl-2-pyrrolidon als reaktivem Lösungsmittel. Durch diese Offenlegungsschrift wird die Erfindung nicht nahegelegt.

Aufgabe der Erfindung ist die Bereitstellung einer Reinigungszusammensetzung, mit der alle Flußmittelreste und/oder Rückstände von der Unterlage entfernt werden können, ohne daß der Rest der Moduln negativ beeinflußt wird.

Ein abdichtender Überzug kann auf die Schaltkreismoduln aufgetragen werden, nachdem die integrierten Halbleiterchips darauf befestigt wurden, um deren Rückseite zu schützen, wodurch die Halbleiterchips vor Korrosion und/oder Elektromigration geschützt werden können. Wenn integrierte Halbleiterchips mehrfach auf einer Unterlage angeordnet werden und/oder wenn Mehrfachunterlagen durch Aufeinanderschichten miteinander verbunden werden sollen und der oberste Überzug dazu dient, die einzelnen Substrate miteinander zu verbinden, würde der Ausfall eines Chips dazu führen, daß die gesamte integrierte Halbleiterschichtung weggeworfen werden müßte, es sei denn, der abdichtende Überzug könnte ohne Zerstörung des restlichen Moduls entfernt werden.

Aufgabe der Erfindung ist deshalb auch, eine Reinigungszusammensetzung bereitzustellen, mit der der abdichtende Überzug von einer Unterlage entfernt werden kann, ohne daß das restliche Modul zerstört wird. Dadurch wird die Entfernung und der Ersatz fehlerhafter Chips ermöglicht, so daß der Rest des integrierten Halbleitermoduls erhalten bleibt und wieder verwendet werden kann.

Die Aufgabe der Erfindung wird gelöst durch eine Reinigungszusammensetzung, die gemäß Patentanspruch 1 dadurch gekennzeichnet ist, daß sie aus 50 bis 95 Gew.-% N-Methyl-2-pyrrolidon und 50 bis 5 Gew.-% eines mit Wasser mischbaren Alkanolamins besteht.

Die Erfindung betrifft auch ein Verfahren zur Herstellung der Reinigungszusammensetzung und die Verwendung dieser Reinigungszusammensetzung.

Mit der erfindungsgemäßen Reinigungszusammensetzung können Lötflußmittelreste und/oder Rückstände und abdichtende Überzüge, beispielsweise aus Polyimiden, von Unterlagen ohne nachteilige Beeinflussung derselben und des restlichen Moduls entfernt werden.

Ein Materialtyp zur Abdichtung von Halbkreismoduln besteht aus einem gehärteten Polymerüberzug, der als Bindemittel ein Polyimid enthält. Die Polyimide sind gehärtete Polymere aus Polyamiden oder Polyamidsäuren, welche Imidgruppierungen entlang der Polymerkette enthalten, die durch Kondensation der Amidform mit der Säuregruppe der Polymerkette entstanden sind. Polymere dieser Art sind bekannt und werden hergestellt durch Umsetzung von wenigstens einem Diamin mit wenigstens einer Polycarbonsäure und/oder einem Säureanhydrid und/oder einem Ester derselben. Die erfindungsgemäße Reinigungszusammensetzung muß in der Lage sein, einen gehärteten Polyimidüberzug von der Unterlage zu entfernen.

N-Methyl-2-pyrrolidon ist als Lösungs- und Reinigungsmittel gut bekannt. Es wurde in Kombination mit anderen Bestandteilen zum Ablösen oder Entformen verwendet. Beispielsweise ist in der US-PS 3 673 099 eine Zusammensetzung mit einem Gehalt an N-Methyl-2-pyrrolidon und einer starken Base, wie einem Alkalimetallhydroxid, beschrieben und deren Verwendung zur Entfernung bestimmter gehärteter Harze, wie Silicone oder Polyvinylcinnamat, von Unterlagen. Aus der US-PS 3 876 461 ist das Eintauchen von mit Kunststoff umhüllter Halbleitervorrichtungen in N-Methyl-2-pyrrolidon bekannt. In der US-PS 3 706 691 ist das Auflösen bestimmter Einkapselungsmaterialien wie Polyamide, Polyester und bestimmter Polyurethane beschrieben, die durch das Einwirken einer heißen feuchten Atmosphäre zerstört worden waren. Hierzu wird eine Zusammensetzung mit einem Gehalt an Benzyltrimethylammoniumhydroxid in Kombination mit N-Methyl-2-pyrrolidon verwendet. In keiner der zuvor genannten Patentschriften sind die Zusammensetzungen gemäß der vorliegenden Erfindung mit einem Gehalt an N-Methyl-2-pyrrolidon beschrieben. Auch ist nirgends zu finden, daß diese Flußmittel und/oder Flußmittelrückstände entfernen können und nach entsprechender Modifizierung in der Lage sind, gehärtete abdichtende Polymerüberzüge, wie gehärtete Polyimide, zu entfernen.

In der US-PS 3 331 718 wird die Entfernung von Polyamid/Imidfilmen mit starken Alkalien beschrieben, aber auch hier ist die Verwendung von Zusammensetzungen mit den erfindungsgemäßen Bestandteilen nicht angegeben.

In der US-PS 3 551 204 sind Zusammensetzungen zur Auflösung von Polyurethanen und Epoxidharzsystemen angegeben, welche etwa 0,1 bis 3 Gewichtsteile Wasser, etwa 3 bis 7 Gewichtsteile Alkalimetallhydroxide und etwa 90 bis 96,9 Gewichtsteile bestimmter einwertiger Alkohole oder bestimmter Äthylenglykolmonoalkyläther enthalten. In dieser Patentschrift wird die Zugabe sehr kleiner Mengen (bis zu etwa 5 oder 10%) anderer Lösungsmittel, einschließlich Methylpyrrolidon (Spalte 3, Zeilen 10 bis 18) angegeben.

Die Erfindung wird anhand der speziellen Beschreibung näher erläutert.

Die Zusammensetzungen der vorliegenden Erfindung bestehen aus N-Methyl-2-pyrrolidon und einem mit Wasser mischbaren Alkanolamin. Zusammensetzungen dieser Art sind besonders geeignet zur Entfernung von Lötflußmitteln und Rückständen desselben von einer Unterlage, beispielsweise von Eingangs- und Ausgangsstiften und einem keramischen Träger für integrierte Schaltkreischips, sowohl vor wie auch nach der Befestigung der integrierten Schaltkreischips.

Die Alkanolamine, die erfindungsgemäß verwendet werden, sind vorzugsweise wasserlöslich und müssen mit N-Methyl-2-pyrrolidon mischbar sein. Zusätzlich sollten diese Amine relativ hochsiedende Materialien mit Siedepunkten über 100°C darstellen und hohe Flammpunkte, beispielsweise über 65,5°C, aufweisen. Die Alkanolamine können primäre, sekundäre oder tertiäre Amine sein, d. h. Monoamine, Diamine oder Triamine und vorzugsweise Monoamine. Die Alkanolgruppe des Amins ist vorzugsweise ein nichtsubstituiertes Monoalkanol und enthält vorzugsweise 1 bis 4 Kohlenstoffatome. Beispiele geeigneter Alkanolamine schließen Monoäthanolamin, Diäthanolamin, Triäthanolamin, Isopropanolamin, 2-Amino-1-propanol, 3-Amino-1-propanol und Isobutanolamin ein. Die bevorzugten Alkanolamine, die erfindungsgemäß verwendet werden, sind Monoäthanolamin, Diäthanolamin und Triäthanolamin. Wenn es gewünscht wird, können auch Mischungen der Alkanolamine verwendet werden.

Die Gegenwart des Alkanolamins beschleunigt die lösende Wirkung der Zusammensetzung. Obgleich Methylpyrrolidon, besonders bei höheren Temperaturen, in der Lage ist, bestimmte Flußmittelflecken, die auf die Polymerisation des Flußmittels bei den während des Lötens auftretenden höheren Temperaturen zurückzuführen sind, zu entfernen, erfolgt das Entfernen mit langsamer Geschwindigkeit und nimmt eine beträchtliche Zeit in Anspruch. Die Anwesenheit des Alkanolamins reduziert die Zeit, die zur Entfernung notwendig ist, erheblich. Bei Verwendung eines Alkanolamins ist es auch möglich, Flecken oder Rückstände von Lötflußmitteln, die sich durch Methylpyrrolidon allein kaum entfernen lassen, zu entfernen. Außerdem wird angenommen, daß die verwendeten Alkanolamine als Netzmittel wirken und dadurch die Entfernung der Reinigungslösung von der Unterlage nach dem Kontakt mit derselben durch Waschen erleichtern.

Die Reinigungszusammensetzungen gemäß der vorliegenden Erfindung enthalten wenigstens etwa 50 Gew.-% N-Methyl-2-pyrrolidon, vorzugsweise wenigstens etwa 75 Gew.-% und besonders bevorzugt wenigstens etwa 90 Gew.-%. Weiterhin enthalten die Zusammensetzungen gemäß der vorliegenden Erfindung wenigstens etwa 5 Gew.-% eines Alkanolamins, und vorzugsweise wenigstens etwa 10 Gew.-% Alkanolamin.

Die zuvor angegebenen relativen Mengen basieren auf dem Gesamtgehalt von N-Methyl-2-pyrrolidon und Alkanolamin in der Zusammensetzung. Weiterhin sollten die Zusammensetzungen der vorliegenden Erfindung im wesentlichen (weniger als 5 Gew.-%), wenn nicht vollständig, frei von Wasser sein, denn die Anwesenheit von mehr als etwa 5 Gew.-% Wasser verhindert die Entfernung

3

des Flußmittels und/oder seiner Rückstände ganz wesentlich.

Es ist auch möglich, der Zusammensetzung andere Lösungsmittel zuzugeben, vorausgesetzt, daß sie nicht in solchen Mengen vorliegen, daß die Zusammensetzungen in unerwünschtem Maße nachteilig beeinflußt werden. Es können beispielsweise bis zu etwa 35 Gew.-% Kohlenwasserstoff-Lösungsmittel wie aromatische Kohlenwasserstoffe, beispielsweise Toluol und Xylol; cycloaliphatische Kohlenwasserstoffe wie Cyclohexan; Ketone wie Cyclohexanon und chlorierte Kohlenwasserstoffe wie Perchloräthylen und fluorierte Kohlenwasserstoffe, die unter dem Warenzeichen Freon im Handel erhältlich sind, beispielsweise Tetrafluoräthan, verwendet werden.

Die Zusammensetzungen der vorliegenden Erfindung können auch in kleineren Mengen (weniger als 5 Gew.-%) ein oberflächenaktives Mittel enthalten, beispielsweise kationische, anionische und amphotere grenzflächenaktive Stoffe. Als Beispiel für einen geeigneten grenzflächenaktiven Stoff ist Natriumlaurylsulfat zu nennen.

Unterlagen, die gemäß der Erfindung behandelt werden, sind diejenigen Unterlagen, die im allgemeinen zur Herstellung integrierter Schaltkreismoduln verwendet werden, oder Träger wie keramische Substrate. Eine Keramik ist ein Produkt oder ein Material, das durch Einwirkung von Hitze auf rohe erdige Materialien entsteht. Bevorzugte keramische Unterlagen enthalten Aluminiumoxide, Siliciumoxide und Silicate, beispielsweise Aluminiumsilicat. Die Flußmittel, oder die Rückstände derselben, welche mit den zuvor beschriebenen Reinigungslösungen behandelt werden können, sind diejenigen Flußmittel, die besonders zur Herstellung integrierter Schaltkreismoduln geeignet sind und schließen diejenigen Zusammensetzungen ein, in denen Abietinsäure der wichtigste oder primäre Flußmittelbestandteil ist, beispielsweise Mischungen wie Kolophonium und Schellack, welche große Mengen Abietinsäure enthalten; außerdem kommen Polyalkylenglykole, Polyoxyalkylenäther oder Mischungen derselben infrage.

Die Alkylenbestandteile der Glykole und Äther schließen Äthylen, Propylen und Butylen oder Mischungen derselben und besonders bevorzugt Äthylen ein. Glykole und Äther der genannten Art haben im allgemeinen Molekulargewichte von etwa 200 bis etwa 6000. Einige im Handel erhältliche Polyalkylenglykole und Polyoxyalkylenäther schließen

Carbowax 300 — Monostearatform $HO(CH_2CH_2O)_5CH_2CH_2OOC(CH_2)_{16}CH_3$;
Carbowax 400 — Monolauratform $HO(CH_2CH_2O)_8CH_2CH_2OOC(CH_2)_{10}CH_3$ und
Carbowax 400 — Monooleatform $(C_{36}H_{70}O_{11})$

ein. Ein Beispiel für einen Polyoxyalkylenäther ist das im Handel von der Dow Chemical Company unter der Bezeichnung P-15-200 erhältliche Produkt. P-15-200 ist nach Herstellerangaben ein Polyoxyalkylenäther mit Methylseitenketten und endständigen Hydroxylgruppen. Die Zahl 200, die auf 15 folgt, gibt die Viskosität des Materials in cSt bei 37,8° C an.

Mischungen der wesentlichen Flußmittelbestandteile können in jeder der üblicherweise verwendeten Flußmittelzusammensetzungen vorliegen. Außerdem können die Flußmittelzusammensetzungen andere Bestandteile enthalten, beispielsweise Weichmacher und zusätzliche Bindemittel.

Mit den zuvor beschriebenen Zusammensetzungen können auch organische polymere Lötmaskenzusammensetzungen von den behandelten Unterlagen entfernt werden. Lötmaskenzusammensetzungen dieser Art können hergestellt werden aus Mischungen, welche als filmbildende Polymerbestandteile ein flüssiges Polyepoxid oder ein Polyimid/Amid; ein das Kleben verhinderndes Mittel und einen festen, hochtemperaturbeständigen Füllstoff enthalten. Bevorzugte Lötmaskenzusammensetzungen dieser Art sind in der europäischen Patentanmeldung 80 102 680.8, welche eine in Siebdruck verarbeitbare und wieder entfernbare Lötmaskenzusammensetzung und deren Verwendung betrifft, beschrieben.

Die bevorzugten Polyimide/Amide in diesen Lötmaskenzusammensetzungen haben Molekulargewichte von etwa 500 bis 2500, und die flüssigen Epoxide sind vorzugsweise Polyepoxide aus Epichlorhydrin und 2,2-Bis(4-hydroxyphenyl)-propan (Bisphenol A). Zusätzlich enthalten diese Zusammensetzungen ein das Kleben verhinderndes Mittel aus der Gruppe der flüssigen Siliconöle, der Terpene, α-Terpineole, der trocknenden Öle und Mischungen derselben. Wenn das filmbildende Polymer ein flüssiges Polyepoxid ist, enthält das das Kleben verhindernde Mittel ein Siliconöl.

Die Füllstoffe, die in solchen Zusammensetzungen im allgemeinen verwendet werden, haben eine Teilchengröße von etwa 0,1 bis 20 μm und vorzugsweise von etwa 0,1 bis 5 μm. Füllstoffe dieser Art müssen hohen Temperaturen, denen sie während des Lötens ausgesetzt werden, standhalten. Sie sollten wenigstens Temperaturen von etwa 300° C und vorzugsweise von wenigstens 350° C aushalten. Das Lot wird im allgemeinen bei Temperaturen zwischen etwa 300 und 400° C angewendet. Beispiele einiger geeigneter fester, hochtemperaturbeständiger Füllstoffe sind gemahlenes Glas, Zinkoxid, Siliciumdioxid, Aluminiumoxid, Diamantstaub und hochtemperaturbeständige Sandsorten.

Das Verhältnis des filmbildenden Polymers des Polymeranteils der Zusammensetzung relativ zu dem das Kleben verhindernden Mittel liegt zwischen etwa 2 : 1 und 1 : 3, vorzugsweise zwischen etwa 1 : 1 und 2 : 3. Die Menge an Füllstoff, die relativ zu der filmbildenden Polymerkomponente des Polymeranteils der Zusammensetzung verwendet wird, liegt bei etwa 1 : 3 bis etwa 6 : 1 und vorzugsweise bei etwa 2 : 1 bis 6 : 1.

Unterlagen, die mit einer der zuvor beschriebenen Zusammensetzungen behandelt werden sollen, werden, während diese sich auf eine Temperatur von etwa 35 bis 100° C, vorzugsweise von etwa 50 bis

4

90 C und besonders bevorzugt von etwa 60 bis 85°C befindet, behandelt. Der Kontakt mit der Unterlage wird herbeigeführt durch Eintauchen in einen Kessel, der die Zusammensetzung enthält. Die Behandlungszeit ist im allgemeinen zwischen etwa 10 Sekunden und 30 Minuten. Die Temperatur der Zusammensetzung und die Behandlungszeit sind zueinander invers, d. h., je höher die Behandlungstemperatur ist, desto kürzer ist die für eine vollständige Entfernung erforderliche Behandlungszeit. Eine Kontaktzeit von etwa 2 Minuten für eine Zusammensetzung aus etwa 90 Gew.-% N-Methyl-2-pyrrolidon und etwa 10 Gew.-% Triäthanolamin bei einer Temperatur von etwa 65°C ± 5°C ist für ein gewerbliches Verfahren besonders geeignet. Es wurde beobachtet, daß die zuvor beschriebene, spezifische Zusammensetzung Flußmittelrückstände bei Temperaturen unter 35°C nicht mehr entfernte und daß bei Temperaturen zwischen 35 und etwa 40°C Behandlungszeiten von etwa 23 Minuten für die Entfernung erforderlich waren.

Während der Behandlung kann die Zusammensetzung etwas bewegt werden, beispielsweise durch Rühren oder Schütteln, um den Kontakt der Zusammensetzung mit schwer erreichbaren Teilen der Unterlage zu erleichtern. Die Zusammensetzung kann auch zu einem Wärmeaustauscher rückgeführt werden, um die Temperatur der Zusammensetzung aufrechtzuerhalten und zu kontrollieren.

Die Unterlagen können nach dem Behandeln mit der Zusammensetzung und nach ihrer Entfernung aus derselben mit Wasser gespült werden, um zurückbleibende Reste der Reinigungszusammensetzung zu entfernen. Es wird angenommen, daß während dieses Behandlungsschrittes die Amine der Reinigungszusammensetzung als grenzflächenaktiver Stoff wirken. Wenn es gewünscht wird, können die Unterlagen auch getrocknet werden, beispielsweise durch Luft, welche über die Unterlagen geblasen wird.

Um von der Oberfläche einer Unterlage einen gehärteten Überzug aus Polyimid, der zur Versiegelung aufgetragen wird, zu entfernen, ist es erforderlich, die zuvor angegebenen Reinigungslösungen zu modifizieren, indem eine Alkalimetallbase und/oder eine Erdalkalimetallbase zugefügt wird. Geeignete Alkalimetall- und/oder Erdalkalimetallbasen schließen basische Verbindungen der Alkali- und Erdalkalimetalle wie Hydroxide, Oxide und Alkoholate ein. Beispiele einiger geeigneter Metalle sind Lithium, Natrium, Kalium, Calcium und Magnesium. Beispiele einiger spezifischer, basischer Verbindungen sind Lithiumhydroxid, Natriumhydroxid, Kaliumhydroxid und Calciumhydroxid. Wenn es gewünscht wird, können auch Mischungen der basischen Materialien angewendet werden. Die Base sollte mit der Methylpyrrolidon-Alkanolamin-Kombination mischbar sein. Im allgemeinen wird die Alkalimetallbase und/oder Erdalkalimetallbase angewendet in Mengen von etwa 0,1 bis 10 Gew.-%, bezogen auf den Gesamtgehalt an Methylpyrrolidon, Alkanolamin und Alkalimetallbase und/oder Erdalkalimetallbase der Zusammensetzung. Zusammensetzungen, die die genannten basischen Materialien enthalten, weisen im allgemeinen einen pH-Wert von etwa 10 auf, was mit Lackmuspapier festgestellt wird.

Es ist überraschend, daß die Zusammensetzungen gemäß der vorliegenden Erfindung gehärtetes Polyimid entfernen, ohne daß die Metallurgie auf der Unterlage, beispielsweise Chromleiterzüge, beschädigt werden, obgleich es bekannt ist, daß sich Chrom in Alkalien löst und alkalische Zusammensetzungen mit einem pH-Wert von 10 oder mehr Chrom ätzen. Die Zusammensetzungen der vorliegenden Erfindung ätzen jedoch Chrom nicht, sogar wenn dieses 24 Stunden lang bei etwa 100°C der alkalischen Zusammensetzung ausgesetzt wird. Die modifizierten Zusammensetzungen entfernen zusätzlich zu den gehärteten Überzügen, welche zur Versiegelung aufgetragen werden, alle Substanzen, die durch die Zusammensetzungen, die nur N-Methyl-2-pyrrolidon und Alkanolamin enthalten, auch entfernt werden.

Diese modifizierten Zusammensetzungen sind auch in der Lage, belichtete organische Photoresistmaterialien, die aus Polyvinylcinnamat, Polyvinylacrylat, Polyalkylacrylaten und Polyalkylmethacrylaten, wie Polymethylmethacrylat (das unter dem Handelsnamen Riston von Du Pont erhältlich ist) bestehen, zu entfernen. Mit den modifizierten Zusammensetzungen können auch getrocknete Überzüge aus Zusammensetzungen entfernt werden, die Bindemittel wie Polyalkylacrylate und Polyalkylmethacrylate und trocknende Öle wie natürliche trocknende Öle, einschließlich Leinsamenöl, Tungöl und dgl. enthalten.

In den Zusammensetzungen der vorliegenden Erfindung, welche Alkalimetall- und/oder Erdalkalimetallbasen enthalten, wirkt das Alkanolamin auch als Stabilisierungsmittel, das ein Ausfallen der Alkalimetall- und/oder Erdalkalimetallbase verhindert. Die Zusammensetzungen, welche Alkalimetall- und/oder Erdalkalimetallbasen enthalten, werden vorzugsweise hergestellt durch Auflösen derselben in dem Alkanolamin unter Anwendung höherer Temperaturen, beispielsweise bei 125 bis 170°C. Anschließend wird die Zusammensetzung aus Alkanolamin und Alkalimetall- und/oder Erdalkalimetallbase mit dem Methylpyrrolidon gemischt. Durch diese Reihenfolge wird die Zusammensetzung stabilisiert und ein Ausfallen der Alkalimetall- und/oder Erdalkalimetallbasen verhindert.

Typische Polyimidüberzüge, die zur Versiegelung verwendet werden, enthalten ein aromatisches Polyimidharz wie AIP-10 von AMOCO, welches aus Pyromellitsäuredianhydrid und 4,4'-Diaminodiphenyläther hergestellt wird und eine kleine Menge (etwa 1 bis 2 Gew.-%) eines Silans wie β(3,4-Epoxycyclohexyl)-äthyltrimethoxysilan, γ-Aminopropyltriäthoxysilan, N-Bis(β-hydroxyäthyl)-γ-aminopropyltriäthoxysilan, N-β(Aminoäthyl)-γ-aminopropyl-trimethoxysilan und γ-Glycidoxypropyltri-

methoxysilan.

Einige Beispiele aromatischer Polyimide sind in der US-PS 3 331 718 und in der zuvor erwähnten US-Patentanmeldung Serial Nr. 045 524 beschrieben.

Die Polyimidüberzüge, die zur Versiegelung verwendet werden, enthalten keinen festen, hochtemperaturbeständigen Füllstoff in denjenigen Mengen, die in der zuvor beschriebenen Lötmaskenzusammensetzung enthalten sind, und die bewirken würden, daß dieser abdichtende Überzug von der Unterlage nur mit einer Kombination aus N-Methyl-2-pyrrolidon und Alkanolamin entfernt werden könnte.

Die modifizierten Zusammensetzungen, welche Alkalimetall- und/oder Erdalkalimetallbasen enthalten, werden, wenn sie zur Entfernung eines gehärteten abdichtenden Überzugs, beispielsweise aus gehärteten Polyimiden verwendet werden, im allgemeinen bei erhöhten Temperaturen von 100 bis etwa 200°C und vorzugsweise von etwa 115 bis 150°C angewendet. Die Behandlungszeiten zur Entfernung der Zusammensetzungen hängen von der Schichtdicke des zu entfernenden Überzugs ab. So sind beispielsweise zur Entfernung eines Überzugs von 80 bis 150 μm Schichtdicke bei den zuvor angegebenen Temperaturen etwa eine halbe Stunde bis etwa 3 Stunden und vorzugsweise etwa 1 Stunde bis etwa 1½ Stunden erforderlich, und für einen Überzug von etwa 0,0085 mm bis etwa 0,0254 mm Schichtdicke sind bei den zuvor angegebenen Temperaturen etwa 5 bis 10 Minuten erforderlich. Nach dem Kontakt mit der Lösungsmittelzusammensetzung können die Unterlagen mit Wasser gewaschen und dann durch Einwirken von heißer oder kalter Luft getrocknet werden.

Wenn die zuvor angegebenen Zusammensetzungen zur Entfernung eines abdichtenden Überzugs verwendet werden, was erwünscht ist, wenn ein defektes Chip von der Unterlage entfernt werden soll, dann wird die Unterlage genügend hohen Temperaturen ausgesetzt, um die Lötverbindungen zu schmelzen, mit denen die Chips mit der Unterlage verbunden sind. Die Chips können dann entfernt und ersetzt werden. Die Zusammensetzungen der vorliegenden Erfindung können nicht nur zur Behandlung von integrierten Schaltkreismoduln, sondern ganz allgemein zur Behandlung von Unterlagen verwendet werden, bei denen die zuvor angegebenen Materialtypen von der Oberfläche entfernt werden sollen.

Die nachfolgenden Beispiele dienen der Erläuterung der Erfindung.

## Beispiel I

Etwa 920 ml N-Methyl-2-pyrrolidon und etwa 80 ml Triäthanolamin werden zu einer Reinigungszusammensetzung gemischt. Keramische integrierte Schaltkreismoduln, welche Flußmittelflecken und Rückstände auf und in der Unterlage aufweisen, werden in diese Zusammensetzung getaucht, die sich in einem Kessel befindet und auf etwa 85°C erhitzt wurde. Auf der keramischen Unterlage, die aus Aluminiumoxid besteht, ist eine Chrom- und Kupfermetallurgie angeordnet, außerdem enthält erstere vergoldete Eingangs- und Ausgangsstifte. Die Flußmittelflecken oder Rückstände rühren von einer Flußmittelzusammensetzung her, welche Kolophonium und als Lösungsmittel Isopropylalkohol enthielt. Die Unterlagen werden etwa 2 Minuten lang in die Reinigungszusammensetzung getaucht. Anschließend werden sie eine halbe Minute lang mit N-Methyl-2-pyrrolidon behandelt, um das Lösungsmittel abzuspülen und dann eine halbe Minute lang in Wasser gespült und durch Aufblasen von Luft getrocknet.

Die Zusammensetzung der vorliegenden Erfindung entfernte alles Flußmittel und alle Flußmittelrückstände von den Unterlagen und den Stiften. Moduln, welche infolge eines Staus während des Lötens zu lange den hohen Temperaturen des Lötvorgangs ausgesetzt waren, enthielten einigen verkohlten Rückstand, der weder durch die zuvor beschriebene Zusammensetzung noch durch irgendeine andere bekannte Zusammensetzung entfernt werden konnte. Die Kupfer- und Chrommetallurgie und die anderen Teile der Unterlage wurden durch die Reinigungszusammensetzung nicht angegriffen.

## Beispiel II

Etwa 49,25 g Triäthanolamin werden auf etwa 130°C erhitzt, und etwa 0,15 g Natriumhydroxid werden unter Rühren dem heißen Triäthanolamin zugesetzt. Das Natriumhydroxid, das zugesetzt wird, liegt in Pulverform vor, und es ist etwa 1 Stunde erforderlich, bis es in Lösung gegangen ist. Wenn Natriumhydroxidplätzchen verwendet werden, dauert es etwa 2 bis 3 Stunden, um diese in dem Triäthanolamin zu lösen. Nach Erhalt einer klaren Lösung von Natriumhydroxid in Triäthanolamin werden etwa 50 g N-Methyl-2-pyrrolidon zu der Zusammensetzung zugegeben. Dann wird die Temperatur auf etwa 130±5°C erhöht. Unterlagen wie in Beispiel I, auf denen auch integrierte Halbkreischips festgelötet waren, und die mit einem Überzug aus gehärtetem Polyimid versehen waren, wurden in die erhitzte Lösung, die gerührt wurde, getaucht. Sie wurden etwa 12 Minuten in der Lösung belassen und anschließend mit Wasser gespült. Der gehärtete abdichtende Überzug wurde vollständig von der Unterlage entfernt, ohne nachteilige Beeinflussung anderer Teile des Moduls und/oder des Chips.

Beispiel III

Beispiel I wird wiederholt mit der Ausnahme, daß die verwendete Zusammensetzung etwa 19,2 g Triäthanolamin, etwa 0,8 g Natriumhydroxid, etwa 50 g N-Methyl-2-pyrrolidon und etwa 30 g Cyclohexan enthielt. Die Mischung wird zur Behandlung der Unterlagen auf etwa 90 ± 5° C erhitzt. Die zuvor angegebene Zusammensetzung entfernt auch verschiedene Farbzusammensetzungen, beispielsweise Polyalkylacrylate und trocknende Öle enthaltende Farbzusammensetzungen und Photoresistmaterialien wie Polyvinylcinnamat. Außerdem werden Flußmittelflecken sehr schnell und vollständig entfernt.

Beispiel IV

Beispiel I wird wiederholt mit der Ausnahme, daß die Zusammensetzung etwa 1 g Natriumhydroxid, etwa 23 g Triäthanolamin, etwa 50 g N-Methyl-2-pyrrolidin und etwa 31 g Tetrafluoräthan enthält. Während der Behandlung der Unterlagen befindet sich die Zusammensctzung auf einer Temperatur von etwa 125° C. Es werden ähnliche Ergebnisse wie in Beispiel III erhalten.

**Patentansprüche**

1. Reinigungszusammensetzung, dadurch gekennzeichnet, daß sie aus 50 bis 95 Gew.-% N-Methyl-2-pyrrolidon und 50 bis 5 Gew.-% eines mit Wasser mischbaren Alkanolamins besteht.

2. Reinigungszusammensetzung nach Anspruch 1, dadurch gekennzeichnet, daß das Alkanolamin ein primäres, sekundäres oder tertiäres Amin ist und der oder die Alkanolaminreste unsubstituiert sind und 1 bis 4 Kohlenstoffatome enthalten.

3. Reinigungszusammensetzung nach den Ansprüchen 1 und 2, dadurch gekennzeichnet, daß das Alkanolamin gewählt ist aus der Gruppe von Monoäthanolamin, Diäthanolamin, Triäthanolamin und Mischungen derselben.

4. Reinigungszusammensetzung nach Anspruch 1, dadurch gekennzeichnet, daß sie wenigstens 75 Gew.-%, vorzugsweise 90 Gew.-% N-Methyl-2-pyrrolidon enthält.

5. Reinigungszusammensetzung nach den Ansprüchen 1 bis 4, dadurch gekennzeichnet, daß sie zusätzlich 0,1 bis 10 Gew.-% einer Base aus der Gruppe der Alkalimetall- oder Erdalkalimetallhydroxide, Oxide, Alkoholate und Mischungen derselben enthält.

6. Reinigungszusammensetzung nach Anspruch 5, dadurch gekennzeichnet, daß die Base gewählt ist aus der Gruppe von Lithiumhydroxid, Natriumhydroxid, Kaliumhydroxid, Calciumhydroxid und Mischungen derselben.

7. Verfahren zur Herstellung einer Reinigungszusammensetzung nach den Ansprüchen 5 und 6, dadurch gekennzeichnet, daß die Base in dem Alkanolamin unter Erhitzen desselben auf etwa 125 bis 170° C gelöst und diese Lösung mit N-Methyl-2-pyrrolidon gemischt wird.

8. Verwendung der Reinigungszusammensetzung nach den Ansprüchen 1 bis 4 zur Entfernung von Lötflußmitteln oder Flußmittelrückständen von keramischen Unterlagen mit einer Kupfer- und/oder Chrommetallurgie und aufgelöteten integrierten Halbleiterchips.

9. Verwendung der Reinigungszusammensetzung nach den Ansprüchen 1 bis 4 zur Entfernung von Lötflußmitteln aus der Gruppe von Abietinsäure, Kolophonium, Schellack, Polyalkylenglykol, Polyoxyalkylenglykol oder Mischungen derselben.

10. Verwendung der Reinigungszusammensetzung nach den Ansprüchen 1 bis 4 und 8 bis 9 zur Reinigung von Unterlagen bei Temperaturen von 35 bis 100° C, vorzugsweise 60 bis 85 C.

11. Verwendung der Reinigungszusammensetzung nach den Ansprüchen 1 bis 4 und 5 bis 6 zur Entfernung eines gehärteten Polyimidüberzugs von keramischen Unterlagen.

12. Verwendung einer Reinigungszusammensetzung nach den Ansprüchen 1 bis 4 und 5 bis 6 und 11 zur Entfernung eines gehärteten Polyimidüberzugs von keramischen Unterlagen bei Temperaturen von 100 bis 200° C, vorzugsweise 115 bis 150° C.

**Claims**

1. Cleaning composition, characterized in that it consists of 50 to 95% by weight of N-methyl-2-pyrrolidone and 50 to 5% by weight of a water miscible alkanolamine.

2. Cleaning composition as claimed in claim 1, characterized in that the alkanolamine is a primary, secondary, or tertiary amine, and that the alkanolamine residue or residues are unsubstituted and comprise 1 to 4 carbon atoms.

3. Cleaning composition as claimed in claims 1 and 2, characterized in that the alkanolamine is selected from the group of monoethanolamine, diethanolamine, and triethanolamine, and mixtures thereof.

4. Cleaning composition as claimed in claim 1, characterized in that it contains at least 75% by weight, preferably 90% by weight of N-methyl-2-pyrrolidone.

5. Cleaning composition as claimed in any one of claims 1 to 4, characterized in that it additionally contains 0.1 to 10% by weight of a base selected from the group of alkali metal or alkaline earth metal hydroxides, oxides, alkoholates, and mixtures thereof.

6. Cleaning compositions as claimed in claim 5, characterized in that the base is selected from the group of lithium hydroxide, sodium hydroxide, potassium hydroxide, calcium hydroxide, and mixtures thereof.

7. Method of making a cleaning composition as claimed in any one of claims 5 and 6, characterized in that the base is dissolved in the alkanolamine, with the latter being heated to approximately 125 to 170° C, and in that this solution is mixed with N-methyl-2-pyrrolidone.

8. Use of the cleaning composition as claimed in any one of claims 1 to 4 to remove solder fluxes or flux residues from ceramic substrates with a copper and/or chromium metallurgy and integrated semiconductor chips soldered thereon.

9. Use of the cleaning composition as claimed in any one of claims 1 to 4 to remove solder flux selected from the group of abietic acid, rosin, shellac, polyalkyleneglycol, polyoxyalkyleneglycol, or mixtures thereof.

10. Use of the cleaning composition as claimed in any one of claims 1 to 4 and 8 to 9 for cleaning substrates at a temperature of 35 to 100° C, preferably 60 to 85° C.

11. Use of the cleaning composition as claimed in claims 1 to 4 and 5 to 6 to remove a cured polyimide coating from ceramic substrates.

12. Use of a cleaning composition as claimed in any one of claims 1 to 4 and 5 to 6 and 11, to remove a cured polyimide coating from ceramic substrates at temperatures from 100 to 200° C, preferably 115 to 150° C.

## Revendications

1. Composition de nettoyage caractérisée en ce qu'elle est composée de 50 à 95% en poids de N-méthyl-2-pyrrolidone et de 50 à 5% en poids d'un alcanolamine pouvant être mélangé avec de l'eau.

2. Composition de nettoyage selon la revendication 1, caractérisée en ce que l'alcanolamine constitue un amine primaire, secondaire ou tertiaire, et en ce que le ou les résidus d'alcanolamine ne sont pas substitués et contiennent de 1 à 4 atomes de carbone.

3. Composition de nettoyage selon les revendications 1 et 2, caractérisée en ce que l'alcanolamine est choisie dans le groupe des monoéthanolamines, des diéthanolamines, des triéthanolamines, et de mélanges de ceux-ci.

4. Composition de nettoyage selon la revendication 1, caractérisée en ce qu'elle contient au moins 75% en poids, de préférence 90% en poids, de N-méthyl-2-pyrrolidone.

5. Composition de nettoyage selon l'une quelconque des revendications 1 à 4, caractérisée en ce qu'elle contient en plus de 0,1 à 10% en poids d'une base du groupe comprenant les hydroxydes de métal alcalin ou de métal alcalino terreux, les oxydes, les alcoholates, et les mélanges de ceux-ci.

6. Composition de nettoyage selon la revendication 5, caractérisée en ce que la base est choisie dans le groupe comportant l'hydroxyde de lithium, l'hydroxyde de sodium, l'hydroxyde de potassium, l'hydroxyde de calcium et les mélanges de ceux-ci.

7. Procédé pour obtenir une composition de nettoyage selon l'une quelconque des revendications 5 et 6, caractérisé en ce que la base est dissoute dans l'alcanolamine en la chauffant à une température comprise entre environ 125 et 170° C et en ce qu'on mélange la solution ainsi obtenue avec le N-méthyl-2-pyrrolidone.

8. Utilisation de la composition de nettoyage selon l'une quelconque des revendications 1 à 4 pour enlever des flux de soudure ou des résidus de flux, des supports en céramique comportant une métallisation en cuivre et/ou en chrome sur laquelle sont soudées des microplaquettes semi-conductrices intégrées.

9. Utilisation de la composition de nettoyage selon les revendications 1 à 4 pour enlever des flux de soudure appartenant au groupe de l'acide abiétique, de la colophane, du shellac, du polyalkyleneglycol, du polyoxyalkyleneglycol ou des mélanges de ceux-ci.

10. Utilisation de la composition de nettoyage selon l'une quelconque des revendications 1 à 4 et 8 à 9 pour nettoyer des supports à des températures comprises entre 35 et 100° C, de préférence entre 60 et 85° C.

11. Utilisation des compositions de nettoyage selon les revendications 1 à 4 et 5 à 6 pour enlever un revêtement en polyimide durci des supports en céramique.

12. Utilisation d'une composition de nettoyage selon l'une quelconque des revendications 1 à 4 et 5 à 6 et 11 pour enlever un revêtement en polyimide durci des supports en céramique à des températures comprises entre 100 et 200° C, de préférence entre 115 et 150° C.